# EUROPEAN PATENT APPLICATION

(11) **EP 4 757 512 A1**
(43) Date of publication of application: **10.06.2026**
(21) Application number: 24218153.5
(22) Date of filing: 06.12.2024
(51) Int. Cl.: H05K 7/20, B01D 46/00, H02B 1/56

(54) **FILTER HOUSING WITH WAVY GRID**

(71) Applicant: Seifert Systems Ltd., 3000 Birzebbuga (MT)
(72) Inventor: Seifert, Michael Rudi, Madliena, SWQ1015 (MT); Zammit, Glenn, Ibragg, SWQ2062 (MT); Camilleri, Alexander, Haz-Zebbug, ZBG1675 (MT)
(74) Representative: Meissner Bolte Partnerschaft mbB

(57) **Abstract**

The present invention pertains to a filter housing 1 for mounting a filter element 2 of a filter fan assembly in an opening of an enclosure such as a switching cabinet, comprising a, preferably rectangular, frame 11 that is mountable in the opening of the enclosure, wherein the frame 11 comprises a protective grille 13 defining a rear side of the filter housing 1 which is configured to face the inside of the enclosure when the filter housing 1 is mounted in the opening of the enclosure, and, preferably four, side elements 14a, 14b, 14c, 14d that and protrude from the edges of the protective grille 13 to circumscribe a nesting space for accommodating a filter element 2 in front of the protective grille 13; and a cover 12 that is mountable to the frame 11 such that the cover 12 forms a front side of the filter housing 1 which is configured to face the outside of the enclosure when the filter housing is mounted in the opening of the enclosure. The filter element 2 is enclosable between the protective grille 13 and the cover 12, wherein the protective grille 13 comprises a plurality of vertical grille struts 15 with a plurality of protrusions 15a, which extend towards the cover 12, and which are configured to support the filter element 2 such that the filter element 2 is not in full contact with the vertical grille struts 15. The invention also pertains to a filter fan assembly comprising the filter housing.

## Description

The present invention relates to a filter housing for mounting a filter element of a filter fan assembly according to the subject matter of claim 1, as well as to a filter fan assembly according to the subject matter of claim 13.

Filter housings of the type proposed in the present disclosure are, in principle, known in the art, e.g. from EP 1 909 548 B1. Such housings are used to mount a filter element in an opening of an enclosure such as a switching cabinet. Enclosures like switching cabinets, which are equipped with electric or electronic equipment, require means to cool the interior space in which the equipment is housed. For this purpose, the enclosure comprises an opening at the vicinity of which a fan is placed. The fan operates to suck air from an external surrounding of the enclosure into the interior space. In order to suppress the ingress of dust as much as possible, it is desirable to mount a filter element like a fleece mat at the opening of the enclosure front of the fan, by placing a filter housing in the opening of the enclosure, in which the filter element can be accommodated.

A problem associated with filter housings of the type described above is that, although an ingress of dust can be effectively prevented by choice of a suitable filter element, the ingress of water is not suppressed to a satisfactory degree. This problem especially arises when the filter housing is used in a wet environment. The intake of water and air leads to a wetting of the filter element, which ultimately releases water into the interior of the enclosure.

In light of the above, it is an object of the present invention to (further) reduce the ingress of water into an enclosure such as a switching cabinet when air is guided into the enclosure.

The object of the invention is solved by a filter housing according to the subject matter of claim 1, as well as by a filter fan assembly according to the subject matter of claim 13.

In particular, the object is solved by a filter housing for mounting a filter element of a filter fan assembly in an opening of an enclosure such as a switching cabinet, comprising a, preferably rectangular, frame that is mountable in the opening of the enclosure, preferably such that the frame is disposable in front of a fan located in the enclosure, wherein the frame comprises a protective grille defining a rear side of the filter housing which is configured to face the inside of the enclosure when the filter housing is mounted in the opening of the enclosure, and, preferably four, side elements that and protrude from the edges of the protective grille to circumscribe a nesting space for accommodating a filter element in front of the protective grille; a cover that is mountable to the frame such that the cover forms a front side of the filter housing which is configured to face the outside of the enclosure when the filter housing is mounted in the opening of the enclosure; wherein the filter element is enclosable between the protective grille and the cover; and wherein the protective grille comprises a plurality of vertical grille struts with a plurality of protrusions, which extend towards the cover, and which are configured to support the filter element such that the filter element is not in full contact with the vertical grille struts, preferably along their entire vertical extension.

The present invention rests on the finding that the ingress of water into an enclosure can be greatly reduced if a filter housing for mounting a filter element is designed with water-repelling features that are configured to guide water, which is sucked towards the enclosure by the fan and passes through the filter element, towards the outside of the enclosure. The filter housing according to the present invention is particularly designed to minimize the contact between the filter element and the protective grille, which forms the housing element that faces the interior of the enclosure when the filter housing is mounted in the opening of the enclosure. Through the minimization of the contact between the filter element and the protective grille the amount of water that is conveyed from the filter element to the grille when the fan sucks water and air through the filter housing and the filter element disposed therein can also be minimized. In order to achieve this, the protective grille is not designed as a flat grille which comes into full contact with the filter element mounted in the filter housing. Instead, the protective grille comprises vertical grille struts that are not configured as vertically extending straight struts. Instead, the vertical grille struts are provided with protrusions, which extend towards the cover of the filter housing. When the filter element is inserted in the filter housing, the contact between the protective grille and the filter element is limited to the protrusions of the vertical grille struts. In other words, the protective grill, particularly its vertical grille struts, is designed such that the filter element is only supported by the protrusions on the vertical grille struts. In this way, it is ensured that the filter element is not in full contact with the vertical grille struts when it is mounted in the filter housing. Therefore, a flow of water from the filter element to the protective grille is minimized. Water droplets forming on the back side of the filter when water and air are sucked into the enclosure from the exterior can only be transferred to the protective grille at the position of the protrusions, where the filter element is in physical contact with the protective grille. This leads to a substantial reduction of fluid transfer to the part of the filter housing facing the interior of the enclosure, from where water droplets may be sucked into the enclosure by the fan.

The vertical grille struts are designated as vertical grille struts because they are in a vertical orientation when the filter housing is mounted in the opening of the disclosure. In the mounted state of the filter housing, one of the side elements of the frame is located at a vertically highest position and can be designated as top side element, whilst another side element is located at a vertically lowest position and can be identified as bottom side element. The vertical grille struts extend between the top side element and the bottom side element, so that they extend in a vertical direction when the filter element is mounted in the opening of the enclosure.

According to a preferred embodiment, the vertical grille struts have a wave shape or wavy shape such that the vertical grille struts alternately protrude towards and away from the cover along their vertical extension, with the portions protruding towards the cover forming the protrusions. This design of the vertical grille struts is simple to produce, requires a low amount of material to produce the vertical grille struts, whilst providing the desired protrusions for the minimization of contact between the filter element and the protective grille. The portions of the vertical grille struts forming the protrusions may be designated as the wave crests of the wave shape of the vertical grille struts.

Preferably, the wave shape of the vertical grille struts is a periodical wave shape, with protrusions being arranged in substantially equal distances along the vertical extension of the grille struts. According to a preferred embodiment, the vertical grille struts are substantially sinusoidal in shape when viewed from the side, i.e. from the direction of one of the vertical side elements of the frame. A wavy shape of the vertical grille struts bears the advantage that the parts of the wavy shape forming the protrusions for support of the filter element provide a very small area that is in contact with the filter element, thus minimizing contact between the filter element and the protective grille. At the same time, the wavy shape provides a smooth surface on the side of the grille struts facing the filter element, so that droplets forming on the vertical grille struts can flow down the vertical grille struts. Preferably, the period of the wave shape of the vertical grille struts is chosen such that each vertical grille strut has at most 6, preferably at most 5, further preferably at most 4, further preferably at most 3 contact points with the filter element mounted in the filter housing.

It should be noted that, in the context of the present invention, the vertical grille struts are not limited to a wavy or substantially sinusoidal shape. For example, the vertical grille struts may have a shape in which straight, substantially vertical sections alternate with curved sections forming the protrusions. It is only required that the vertical grille struts are configured to provide the protrusions for supporting the filter element on a limited area to minimize the contact between the protective grille and the filter element. It is furthermore preferable that the front side of the vertical grille struts with the protrusions has a smooth shape along the vertical extension of the vertical grille strut, in order to allow droplets forming on the vertical grille struts to run down the vertical grille struts.

It is further preferred that an inclination angle of a front side of the vertical grille struts, i.e. the inclination angle of a surface of the vertical grille struts facing the nesting space of the filter housing, does not exceed 45°, more preferably less than 30°, more preferably less than 20°, more preferably less than 15° along the vertical extension of the vertical grille struts, wherein the inclination angle is measured relative to the vertical direction. This ensures that droplets can be effectively guided along the vertical grille struts to the bottom of the frame.

The filter element is not particularly limited according to the present invention. The filter element is designed to filter dust from the air that is sucked into the enclosure. For this, the filter element is made of an air permeable material. The filter element may be constituted by a filter mat, preferably comprising nonwoven material, with a shape that is fitted to the nesting space of the frame of the filter housing. The filter element may comprise a fibre filter, for example a fibre filter of type G2, G3, or G4, or a pleated filter, for example of type G4. The filter element may comprise a water barrier.

It is further preferable that the vertical grille struts are ribbed, preferably double-ribbed, or comprise vertically extending droplet guiding grooves, that are provided to guide droplets downwards along the vertical grille struts. Preferably, the ribs and/or droplet guiding grooves are formed on a frontside of the vertical grille struts that faces towards the cover of the filter housing. This further improves the liquid repelling properties of the filter housing. Droplets, which may be transferred from the backside of the filter element to the protective grille, form in the guiding grooves and are guided in a downward direction along the guiding grooved under the influence of gravity. Preferably, at least some of the vertical grille struts, preferably all grill struts, have at least one guiding groove for guiding droplets to the bottom of the filter frame. It is particularly preferred that some or all of the vertical grille struts comprise two guiding grooves on the side of the vertical grille struts facing the filter element. In this way, droplets forming on the vertical grille struts are guided to the bottom of the filter housing on the side of the protective grille facing away from the interior of the enclosure, which minimizes the risk that the droplets are sucked into the enclosure by the fan.

According to a further (preferred) embodiment, the side element at the bottom of the frame comprises a draining area, having a surface that is inclined towards the front side of the filter housing, such that droplets transferred from the vertical grille struts to the draining area are guided towards the front side of the filter housing. As explained previously, the frame of the housing comprises side elements that frame the protective grille. The vertical grille struts are designed to allow for the formation of droplets on the side facing the filter element. When the droplets move down the vertical grille struts under the influence of gravity, water collects at the bottom end of the vertical grille struts, which are in contact with the bottom side element of the frame. The inclined draining area ensures that liquid pooling at the bottom end of the vertical grille struts flows along the inclined surface to the front side of the filter housing facing the external side of the enclosure. In this way, the ingress of liquid into the enclosure is further reduced.

Further preferably, the draining area comprises filter support protrusions, that are preferably rib-shaped, and configured to provide a support for the filter element so that droplets can flow out of the filter housing underneath the filter element between the filter support protrusions. This ensures that liquid gathering at the bottom of the vertical grille struts in the draining area can flow to the outside of the enclosure unhindered, without being soaked up by the filter element.

According to a further embodiment of the invention, the frame comprises a flange extending from the side elements for mounting the filter housing to the enclosure. This allows for a simple mounting of the filter housing in the opening of the enclosure. Furthermore, the flange that extends from the side elements of the frame provides a sealing area around the opening of the enclosure which aids to further reduce the ingress of dust and liquid.

Preferably, the flange comprises a gasket for sealing the filter housing against the enclosure. This further reduces the ingress of liquid into the enclosure, since liquid can only enter the enclosure by passing through the filter housing and the filter element mounted therein. The design of the filter housing ensures that liquid passing through the filter element is caught on the front side of the protective grille and guided to the bottom of the frame by dripping down the vertical grille struts and, preferably, to the outside of the enclosure along the draining area of the frame.

According to a further (preferred) embodiment, the cover comprises a plurality of (essentially horizontal) louvers which angle downwardly towards the front side of the filter housing. Downwardly angled louvers promote the flow of droplets settling on the louvers to the outside of the enclosure.

It is further preferred that the filter housing comprises a labelling clip configured to be attachable to one of the louvers. This enables an easy identification of technical information or an indication of the filter housing brand without interfering with the functionality of the filter housing.

It is further preferable that the upper surface of the louvers comprises steps, preferably three steps, that are configured to provide a barrier for water entering the filter housing through the cover. Preferably, the steps extend over (substantially) the entire width of the louver. The steps act as barrier for droplet that settle on the louvers. The steps block the droplets from being sucked into the filter housing.

Preferably, the cover is pivotably couplable to the frame. This allows for an easy opening of the filter housing when the filter is to be replaced. A hingeable connection between the cover and the frame ensures that the cover does not have to be removed when the filter element is exchanged. This simplifies the operation and maintenance of the filter housing.

According to a further embodiment, the cover comprises locking elements configured to engage with corresponding engaging elements on the frame to releasably lock the cover to the frame. This allows for an easy and secure fixation of the cover on the frame.

It is further preferable that the locking elements comprise deformable clips with recesses, and wherein the engaging elements comprise projections complementary to the recesses of the locking elements such that the recesses of the clips are configured to engage with the complementary projections lock the cover to the frame. The deformable clips may comprise actuation elements that can be operated by a used to unlock the clips and allow an opening of the filter housing for maintenance or replacement of the filter element.

The object of the invention is further solved by a filter fan assembly, comprising a filter housing according to the embodiments described above, and a fan that is couplable to the rear side of the filter housing.

The advantages that are achievable with the filter housing described above are also attained with the filter fan assembly according to the present invention. All functions and features described above in the context of the inventive filter housing are also applicable to the filter fan assembly, and vice versa.

It is preferred that the filter fan assembly comprises a fan adapter configured to mount the fan to the filter housing. This facilitates the assembly of the filter fan assembly, since the filter housing can be mounted in the opening of the enclosure, wherein the fan adapter allows for an easy mounting of the fan right behind the filter housing.

In a further preferable embodiment, the filter fan assembly only comprises the filter housing according to the description above, and the fan adapter that is couplable to the filter housing.

For the coupling of the fan adapter to the housing, it is preferable that the filter housing comprises bosses on its backside, and that the fan adapter comprises accordingly arranged and sized mounting holes. The fan adapter is mounted on the filter housing by guiding the bosses through the mounting holes. Preferably, the bosses have a hook-like structure, so that the fan adapted can be locked onto the filter housing by guiding the bosses through the mounting holes and moving the fan adapter downward, so that the hook-like structure of the bosses engages with the mounting holes and secures the fan adapter to the filter housing.

Further preferably, the adapter comprises mounting means for mounting an electrical connector, which is preferably connectable to the fan for supplying power to the fan, and/or wherein the adapter comprises at least one cable guide configured to hold a cable, preferably a cable which is connectable to the electrical connector and/or the fan. This further facilitates the installation of the fan in the filter fan assembly. By securing the electrical connectors and cables required for powering the fan on the fan adapter, preferably on a side of the fan adapter facing away from the filter housing, the electrical connections of the fan can be arranged separately from the filter housing, thus reducing the risk of wetting the electrical connections with water sucked in through the filter housing.

The above and further features and advantages of the present invention will become more readily apparent from the following detailed description of preferred embodiments of the invention with reference to the accompanying drawings, in which:
- Fig. 1a: is a perspective front view of a filter housing with attached fan according to a preferred embodiment of the present invention;
- Fig. 1b: is a perspective back view of the filter housing with attached fan according to Fig. 1a;
- Fig. 2a: is a perspective front view of a filter housing with attached fan according to a preferred embodiment of the present invention with removed cover;
- Fig. 2b: is a perspective front view of a frame of a filter housing according to a preferred embodiment of the present invention;
- Fig. 3a: is a perspective back view of the frame of Fig. 2b;
- Fig. 3b: is a sectional view of a filter housing with inserted filter element according to a preferred embodiment of the present invention;
- Fig. 4a: is a detail view of a top corner of a frame of a filter housing according to a preferred embodiment of the present invention;
- Fig. 4b: shows three sectional views of vertical grille struts according to a preferred embodiment of the present invention;
- Fig. 5: is a detail view of a bottom corner of a frame of a filter housing according to a preferred embodiment of the present invention illustrating a draining area;
- Fig. 6: is a sectional view of a cover of a filter housing according to a preferred embodiment of the present invention;
- Fig. 7: is a perspective view of a filter housing according to a preferred embodiment of the present invention with opened cover which is mounted in an opening of an enclosure;
- Fig. 8a, b: are detail views of a frame and a cover of a filter housing according to a preferred embodiment of the present invention illustrating a hinged connection between frame and cover;
- Fig. 9a,: b are detail views of a frame and a cover of a filter housing according to a preferred embodiment of the present invention illustrating a locking mechanism between frame and cover;
- Fig. 10: is an exploded view of a filter fan assembly according to a preferred embodiment of the present invention.

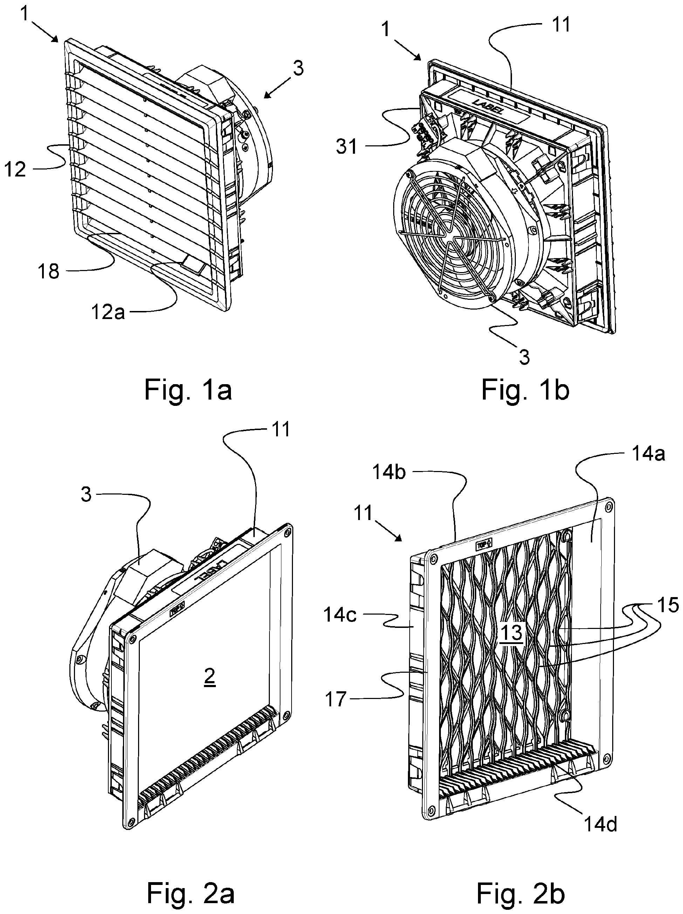

Fig. 1a shows a perspective front view of a filter housing 1 according to a preferred embodiment of the present invention. The filter housing 1 is configured to be mountable in a correspondingly shaped opening of an enclosure such as a switching cabinet. The filter housing 1 serves to mount a filter element (not visible in Fig. 1a) so that it can be positioned in front of a fan 3 located behind the filter element 1. The fan 3 is configured to suck air to the inside of the enclosure, which passes through the filter housing 1 and is filtered by the filter element mounted in the filter housing.

Fig. 1a shows the front side of the filter housing 1 facing the outside of the enclosure when the filter housing 1 is mounted. The front side of the filter housing 1 is formed by a cover 12 that comprises horizontal louvers 18. On one of the louvers 18, a labelling clip 12a is fixated. The labelling clip 12a is configured to carry information such as a brand name or a type specification for the filter fan assembly.

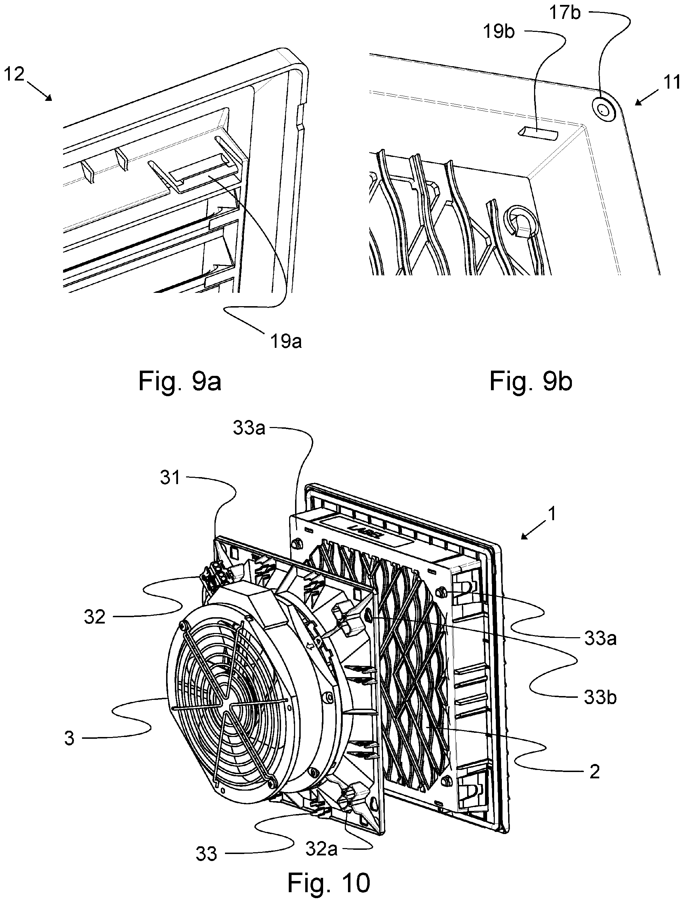

Fig. 1b shows a perspective back view of the filter housing 1 with attached fan 3 of Fig. 1a. The fan 3 is mounted to the filter housing 1 with the aid of a fan adapter 31 which will be described in more detail with reference to Fig. 10 below. The backside of the filter housing 1 is defined by a frame 11. In the embodiment shown in Fig. 1a and 1b, the frame 11 has an essentially rectangular shape.

Fig. 2a shows a perspective front view of the filter housing 1 with attached fan 3 with the cover 12 removed. It can be seen that the frame 11 partially circumscribes a nesting space in which a filter element 2 is placed. The cover 12 is attachable or mountable to the frame 11, so that the filter element 2 is mounted between the frame 11 and the cover 12 when the filter housing 1 is assembled. The filter element 2 can comprise any filter media suitable for filtering air, such as nonwovens, fiber mats or the like.

Fig. 2b is a perspective front view of the frame 11 without the filter element 2. It can be seen that the frame comprises a protective grille 13 which is circumscribed by four side elements 14a, 14b, 14c, 14d, which protrude from the edges of the protective grille 13 towards a front side of the filter housing 1. The protective grille 13 and the side elements 14a, 14b, 14c, 14d delimit the nesting space for accommodating the filter element 2. Fig. 2b shows an orientation of the frame 11 that corresponds to the mounted state of the filter element. The side element 14b is located at the top of the frame 11, and the side element 14d is located at the bottom of the frame 11. From the front edges of the side elements 14a, 14b, 14c, 14d, a flange 17 extends in a direction substantially parallel to the plane in which the protective grille 13 extends. The flange 17 facilitates the mounting of the filter housing 1 in an opening of the enclosure.

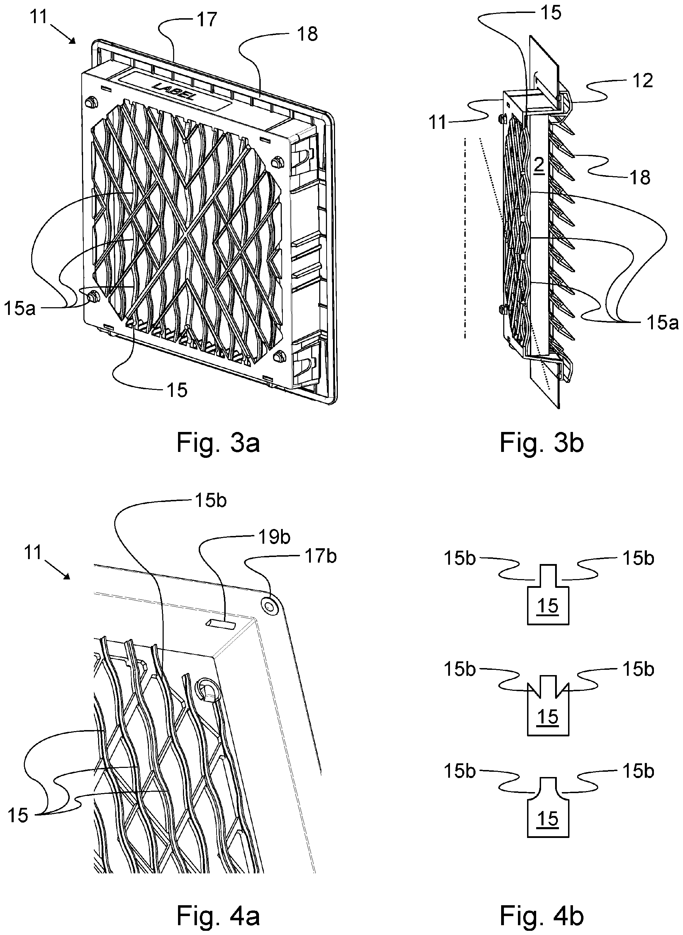

Fig. 3a is a perspective back view of the frame 11. The flange 17 comprises a gasket 18 on its backside, which effects a sealing of the filter housing 1 against the edges of the enclosure's opening when the filter housing 1 is mounted.

It can further be seen in Fig. 3a that the protective grille 13 comprises a plurality of vertical grille struts 15. The vertical grille struts 15 extend along a substantially vertical direction from the upper side element 14b to the bottom side element 14d. As Fig. 3a shows, the vertical grille struts 15 are not fully straight, but have a wavy shape. The parts of the wavy shape which extend towards a front side of the frame 11 (i.e. towards the side of the frame 11 on which the cover 12 is mounted) form protrusions 15a of the vertical grille struts. As it is shown in Fig. 3a, the wavy shape of the vertical grille struts 15 is substantially periodical, with each vertical grille strut forming 4 or 5 wave crests as protrusions 15a which protrude towards the front side of the filter housing 1.

The protrusions 15a of the vertical grille struts 15 serve to support the filter element 2 in the filter housing 1 such that the contact between the filter element 2 and the protective grille 13 is minimized. This is most clearly recognizable in Fig. 3b, which shows a sectional view of the filter housing 1 with mounted filter element 2. It can be seen that the only physical contact between the protective grille 13 and the mounted filter element 2 is through the protrusions 15a of the vertical grille struts 15. The remaining part of the protective grille 13 has no physical contact with the filter element 2. This reduces the risk of transferring water droplets, which may form on the backside of the filter element 2, to the protective grille 13, from where the droplets may be sucked into the enclosure by the fan.

Through the wave shape, the vertical grille struts 15 are, to a large part of their vertical extension, inclined with respect to the vertical direction, which is indicated in Fig. 3b as a dash-dotted line. The dotted line in Fig. 3b indicates the maximum inclination of the vertical grille struts 15. In order to ensure a rapid flow of liquid down the front side of the vertical grille struts 15, it is preferred that the inclination angle of the vertical grille struts 15, i.e. the inclination angle of the front side of the vertical grille struts 15 relative to the vertical direction, is smaller than 45°, more preferably smaller than 30°, more preferably smaller than 20°, more preferably smaller than 15°.

As best visible in Fig. 3a, it may be preferable that a phase of the substantially periodic wave shape two adjacent vertical grille struts 15 is shifted by 180°, so that the horizontal positions of the protrusions 15a of one vertical grille strut 15 are shifted with respect to those of the adjacent vertical grille struts 15. This leads to a more even distribution of support points for the filter element 2 on the protective grille 13.

Fig. 4a shows a detail front view of the frame 11, where the geometry of the vertical grille struts 15 is shown in more detail. The wavy shape of the vertical grille struts 15 with the wave crests acting as protrusions 15a for supporting the filter element 2 with limited physical contact to the protective grille 13 is clearly visible. It is further recognizable that the front face of the vertical grille struts 15 facing the filter element 2 is not flat. Instead, the vertical grille struts 15 are ribbed, such that the front face of each grille strut 15 comprises two droplet guiding grooves 15b which extend vertically along the length of the vertical grille struts. The guiding grooves 15b serve to guide droplets that run down the vertical grille struts 15 to the bottom of the frame 11 on the front side of the protective grille 13. This reduces the risk of droplets being sucked from the protective grille 13 into the fan.

The shape of the droplet guiding grooves 15b is not particularly limited. Fig. 4b shows three cross-sections of vertical grille struts 15 with different shapes of the droplet guiding grooves: (essentially) rectangularly shaped like in Fig. 4a, V-shaped and curved. Preferably, the front side of the vertical grille struts 15 is double-ribbed, i.e. comprises two droplet guiding grooves. Alternatively, it is also possible to provide only one droplet guiding groove 15b on the front face of the vertical grille struts 15.

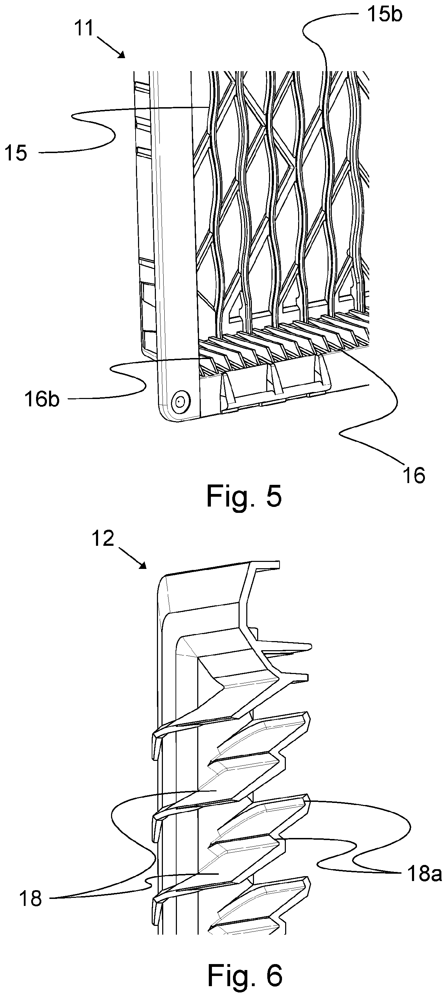

According to a preferred embodiment, the frame 11 comprises further means for guiding liquid that runs down the vertical grille struts 15 to the front side of the filter housing 1. Fig. 5 is a detailed view of a bottom of the frame 11. The bottom side element 14d comprises a draining area 16 which is formed by an inclined surface. The draining area 16 is inclined downwardly towards the front side of the filter housing 1. Droplets that run down the vertical grille struts 15, preferably along the droplet guiding grooves 15b on the front side of the vertical grille struts 16, are guided along the draining area to the front side of the filter housing 1 and, thus, to the outside of the enclosure.

In order to avoid an accumulation of liquid at the bottom of the filter element 2, the draining area 16 further comprises filter support protrusions 16b. The filter support protrusions 16b are fin-shaped. The filter support protrusions 16b are configured to support the filter element 2 such that liquid which is guided to the draining area can flow out of the filter housing 1 between the filter support protrusions 16b and, thus, below the filter element 2.

The cover 12 of the filter housing 1 also contains water-repelling features. Fig. 6 shows a sectional detail view of the cover 12. As noted previously, the cover 12 comprises a plurality of substantially horizontally extending louvers 18. The louvers 18 are inclined downwardly towards the front side of the cover 12. Water settling on the louvers is thus guided to the front side of the filter housing 1. The louvers 18 further comprise a plurality of louver steps 18a. In the embodiment of Fig. 6, each louver comprises two louver steps 18a, but more or less louver steps 18a are also possible. The louver steps 18a extend along substantially the entire width of the louvers 18. Water droplets that may settle on the louvers 18 are blocked from entering the filter housing 18 by the louver steps 18a.

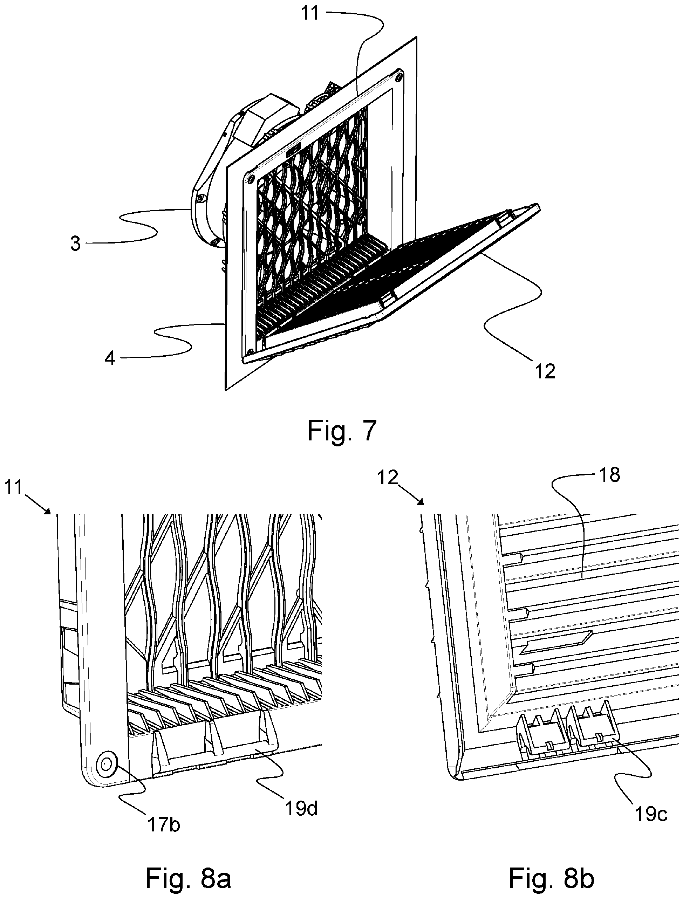

Fig. 7 shows a perspective view of the filter housing 1 in a mounted state. A side wall of the enclosure 4 is shown schematically. The filter housing 1 is mounted in an opening of the enclosure 4, the shape of which corresponds to that of the filter housing 1. The filter housing 1 is in an opened state, which allows the exchange of the filter element 2 in the filter housing 1.

In order to mount the filter housing 1 to the enclosure, the filter housing 1, more specifically the flange 17 of the frame 11, comprises screw hole knockouts 17b, which are most clearly seen in the detail view of the frame 11 in Fig. 8a. If the filter housing 1 is to be mounted to the enclosure with screws, the screws can be driven through the screw hole knockouts 17b. The detail view of Fig. 8a further shows a hinging element 19d located on the bottom part of the frame 11. The hinging element 19d is configured to engage with a correspondingly shaped hinging element 19d on the cover, which is shown in Fig. 8b. With the provision of a hinged connection between the frame 11 and the cover 12, the filter housing 1 is easily operated: if the filter element 2 is to be exchanged, the cover 12 can be pivoted from a closed position to an open position without the need to fully remove the cover 12 from the filter housing 1.

In order to lock the cover 12 to the frame 11 when the filter housing 1 is closed, the top side element 14b of the frame 11 and the top side of the cover 12 preferably comprise a locking mechanism. A possible embodiment of such a locking mechanism is shown in Fig. 9a and 9b. The frame 12 comprises locking elements 19a in the form of deformable tongues with a recess on its backside at the top, as shown in Fig. 9a. The frame 11, more particularly the inner side of the top side element 14b, comprises a correspondingly shaped and dimensioned engaging element 19b. When the cover 12 is pushed onto the frame 11, the locking elements 19a of the cover 12 engage with the locking element 19b of the frame 11, and the cover 12 is locked to the frame 11.

The filter housing 1 of the present invention can be manufactured from a plurality of materials. Particularly preferably, the filter housing 1 is manufactured of a synthetic material, which is preferably UV resistant. Preferably, the elements of the filter housing 1 are manufactured by injection moulding.

The filter housing 1 can be combined with a fan adapter 31, and/or with a fan 3 to form a filter fan assembly. Fig. 10 shows a perspective view of a backside of a filter housing 1, together with a fan adapter 31 to which a fan 3 is mounted. The fan adapter 31 comprises mounting holes 33b that are arranged and dimensioned to engage with corresponding bosses 33a on the backside of the frame 11 of the filter housing 1. The bosses 33a have a hook-like structure, so that the fan adapter 31 can be pushed down after guiding the bosses 33a through the mounting holes 33b, in order to fixate the fan adapter 31 to the filter housing 1.

The fan adapter 31 also creates an additional barrier for liquid that may be sucked through the filter housing by the fan 3. In order to securely mount electrical connections for the fan 3 to the filter fan assembly without bringing the electrical components into contact with liquid, the backside of the fan adapter 31 comprises mounting means 32a for electrical connectors 32. In Fig. 10, one electrical connector is shown, which is mounted to a corresponding mounting means 32a. The mounting means 32a of the fan adapter 31 comprise two holes which may receive corresponding pins or screws for mounting the electrical connector 32. The backside of the fan adapter 31 further comprises a plurality of cable guides 33 which are designed to fixate and guide cables that may be connected to the electrical connector 32 and/or the fan 3.

### List of reference signs

- 1: filter housing
- 11: frame
- 12: cover
- 12a: labelling clip
- 13: protective grille
- 14a-d: side elements
- 15: vertical grille strut
- 15a: protrusion
- 15b: droplet guiding groove
- 16: draining area
- 16b: filter support protrusion
- 17: flange
- 17a: gasket
- 17b: screw hole knockout
- 18: louver
- 18a: louver steps
- 19a: locking element
- 19b: engaging element
- 19c, d: hinging elements

- 2: filter element

- 3: fan
- 31: fan adapter
- 32: electrical connector
- 32a: mounting means for electrical connector
- 33: cable guide
- 33a: boss
- 33b: mounting hole

- 4: enclosure

## Claims

1. Filter housing (1) for mounting a filter element (2) of a filter fan assembly in an opening of an enclosure such as a switching cabinet, comprising
- a, preferably rectangular, frame (11) that is mountable in the opening of the enclosure, wherein the frame (11) comprises a protective grille (13) defining a rear side of the filter housing (1) which is configured to face the inside of the enclosure when the filter housing (1) is mounted in the opening of the enclosure, and, preferably four, side elements (14a, 14b, 14c, 14d) that and protrude from the edges of the protective grille (13) to circumscribe a nesting space for accommodating a filter element (2) in front of the protective grille (13);
- a cover (12) that is mountable to the frame (11) such that the cover (12) forms a front side of the filter housing (1) which is configured to face the outside of the enclosure when the filter housing is mounted in the opening of the enclosure;
wherein the filter element (2) is enclosable between the protective grille (13) and the cover (12);
wherein the protective grille (13) comprises a plurality of vertical grille struts (15) with a plurality of protrusions (15a), which extend towards the cover (12), and which are configured to support the filter element (2) such that the filter element (2) is not in full contact with the vertical grille struts (15).

2. Filter housing (2) according to claim 1, wherein the vertical grille struts (15) have a wave shape such that the vertical grille struts (15) alternately protrude towards and away from the cover (12) along their vertical extension, with the portions protruding towards the cover (12) forming the protrusions (15a).

3. Filter housing (1) according to claim 1 or 2, wherein the vertical grille struts (15) are ribbed, preferably double-ribbed, or comprise vertically extending droplet guiding grooves (15b), that are provided to guide droplets downwards along the vertical grille struts (15).

4. Filter housing (1) according to any of the preceding claims, wherein a side element (14d) at the bottom of the frame (11) comprises a draining area (16), having a surface that is inclined towards the front side of the filter housing (1), such that droplets transferred from the vertical grille struts (15) to the draining area (16) are guided towards the front side of the filter housing (1).

5. Filter housing (1) according to any of the preceding claims, particularly to claim 4, wherein the draining area (16) comprises filter support protrusions (16b), that are preferably rib-shaped, and configured to provide a support for the filter element (2) so that droplets can flow out of the filter housing (1) underneath the filter element (2) between the filter support protrusions (16b).

6. Filter housing (1) according to any of the preceding claims, wherein the frame (11) comprises a flange (17) extending from the side elements (14a, 14b, 14c, 14d) for mounting the filter housing (1) to the enclosure, the flange (17) preferably comprising a gasket (17a) for sealing the filter housing (1) against the enclosure.

7. Filter housing (1) according to any of the preceding claims, wherein the cover (12) comprises a plurality of horizontal louvers (18) which angle downwardly towards the front side of the filter housing (1).

8. Filter housing (1) according to any of the preceding claims, wherein the upper surface of the louvers (18) comprises steps (18a), preferably three steps (18a), that are configured to provide a barrier for water entering the filter housing (1) through the cover (12).

9. Filter housing according to any of the preceding claims, including a labelling clip (12a) configured to be attachable to one of the louvers (18).

10. Filter housing (1) according to any of the preceding claims, wherein the cover (12) is pivotably couplable to the frame (11).

11. Filter housing (1) according to any of the preceding claims, wherein the cover (12) comprises locking elements (19a) configured to engage with corresponding engaging elements (19b) on the frame (11) to releasably lock the cover (12) to the frame (11).

12. Filter housing (1) according to any of the preceding claims, wherein the locking elements (19a) comprise deformable clips with recesses, and wherein the engaging elements (19b) comprise projections complementary to the recesses of the locking elements (19a) such that the recesses of the clips are configured to engage with the complementary projections lock the cover (12) to the frame (11).

13. Filter fan assembly, comprising a filter housing (1) according to any of the preceding claims and a fan (3) that is couplable to the rear side of the filter housing (1).

14. Filter fan assembly according to claim 13, comprising a fan adapter (31) configured to mount the fan (3) to the filter housing (1).

15. Filter fan assembly according to claim 14, wherein the adapter (31) comprises mounting means (32a) for mounting an electrical connector (32), which is preferably connectable to the fan (3) for supplying power to the fan, and/or wherein the adapter (31) comprises at least one cable guide (33) configured to hold a cable, preferably a cable which is connectable to the electrical connector (32) and/or the fan (3).
